# EUROPEAN PATENT APPLICATION

(11) **EP 1 786 112 A2**
(43) Date of publication of application: **16.05.2007**
(21) Application number: 06023339.2
(22) Date of filing: 09.11.2006
(51) Int. Cl.: H04B 1/28

(54) **Apparatus and method for receiving information**

(30) Priority: 10.11.2005 JP 2005325734; 21.04.2006 JP 2006117508
(71) Applicant: SEIKO EPSON CORPORATION, Shinjuku-ku Tokyo 163-0811 (JP)
(72) Inventor: Irie, Michio c/o Seiko Epson Corporation, Nagano-ken 392-8502 (JP)
(74) Representative: HOFFMANN EITLE

(57) **Abstract**

To stably eliminate image interference while preventing complication of the circuit structure.

A channel-selection operating section 16 sends a selected broadcast channel to a local oscillator 13. The local oscillator 13 sets the local oscillation frequency of the local oscillation signal so that the central receiving frequency of the broadcast channel is converted to an intermediate frequency in such a manner that the image frequency falls within an unused band between broadcast channels, thereby preventing the image frequency from coming into the used band of the broadcast channel when converting the received signal to the intermediate-frequency signal, thereby preventing image interference.

## Description

### [Technical Field]

The present invention relates to apparatuses and methods for receiving digital television broadcasts and other information, and in particular, it relates to an apparatus and a method for receiving information advantageous for an information receiving apparatus including a functional part that converts frequencies by mixing a local oscillation signal sent from a local-oscillation-signal source with a received carrier and a method therefore.

### [Background Art]

In Terrestrial Integrated Services Digital Broadcasting (ISDB-T), each broadcasting channel band is divided into a plurality of (14) segments, one of which is assigned as a guard band between the broadcasting channel bands (a no-signal band between the channels). Also, there are signs of popularization of broadcasting using part (one segment) of the thirteen segments except the guard band out of the plurality of segments (what is called one-seg™).

One-segment-digital-broadcasting-capable portable receivers generally use a single super-low-IF architecture to reduce the size, weight, and cost. Here, image cancel mixers are used to eliminate image interference during received-signal frequency conversion.
A technique for heterodyne information receivers has also been proposed in which heterodyne system is switched to the system which has less image interference between an upper heterodyne system and a lower heterodyne system at every receiving frequency in order to reduce the influence of image interfering signals when an intermediate frequency is low (e.g., refer to Patent Document 1).
[Patent Document 1] JP-A-2003-78432

### [Disclosure of the Invention]

### [Problems that the Invention is to Solve]

However, the above-mentioned image cancel mixers have problems of a complicated circuit structure, requiring high-accuracy circuit balance, and lacking stability against fluctuations in source voltage and temperature.
The technique proposed in Patent Document 1 has the possibility of increasing the number of components including signal-level sensors, comparators, and switches which hinder miniaturization and increasing the cost, and furthermore, is likely to delay the receiving operation of the entire apparatus with increasing signal-propagation delay factors due to the complication of the circuit. Furthermore, if both of the upper heterodyne system and the lower heterodyne system generate strong image interference, there is the fear of insufficient image-interference reduction.

The present invention has been made in view of the above-described situation. Accordingly, it is an object of the invention to provide an apparatus and a method for receiving information in which the structure is simplified so that the size, weight, and cost are reduced, and image interference can be stably eliminated.

### [Means for Solving the Problems]

The present application proposes the following technique to solve the above-described problems:
(1) An information receiving apparatus comprising:
   a local oscillator that generates a local oscillation signal whose local oscillation frequency is set so that the image frequency falls within a frequency band that is not used for radio communication or broadcasting;
   a mixer that mixes a received signal with the local oscillation signal to convert the received signal to an intermediate-frequency signal; and
   an intermediate-frequency filter that filters the intermediate-frequency signal.

The information receiving apparatus of (1) can effectively prevent an image frequency from entering a band for use in radio communication or broadcasting when converting a received signal to an intermediate-frequency signal. That is, image interference can be prevented simply by controlling the local oscillation frequency. This eliminates the need to use an image cancel mixer or to use means in which heterodyne system is switched to the system which has less image interference between an upper heterodyne and a lower heterodyne system so as to eliminate image interference, thus improving reception quality while preventing complication of the circuit structure.

(2) An information receiving apparatus comprising:
   a local oscillator that generates a local oscillation signal whose local oscillation frequency is set so that the image frequency falls within an unused frequency band between broadcast channels;
   a mixer that mixes a received signal with the local oscillation signal to convert the received signal to an intermediate-frequency signal; and
   an intermediate-frequency filter that filters the intermediate-frequency signal.

The information receiving apparatus of (2) can effectively prevent an image frequency from entering a band for broadcast channels when converting a received signal to an intermediate-frequency signal. That is, image interference can be prevented simply by controlling the local oscillation frequency. This eliminates the need to use an image cancel mixer or to switch to a heterodyne system with less image interference of the upper heterodyne system and the lower heterodyne system so as to eliminate image interference, thus improving reception quality while preventing complication of the circuit structure.

(3) An information receiving apparatus comprising:
   a local oscillator that generates a local oscillation signal whose local oscillation frequency is set so that the image frequency falls within an unused frequency band between broadcast channels;
   a mixer that mixes a received signal with the local oscillation signal to convert the received signal to an intermediate-frequency signal;
   an intermediate-frequency filter that filters the intermediate-frequency signal; and
   oscillation-frequency switching means that switches the local oscillation frequency of the local oscillator between an upper local oscillation frequency and a lower local oscillation frequency so that the image frequency falls within a broadcast signal band.

The information receiving apparatus of (3) can effectively prevent image interference of all the television broadcast channels by setting the local oscillation frequency so that the image frequency falls within an unused frequency band between broadcast channels.

(4) The information receiving apparatus according to (3), wherein if the image frequency falls out of the broadcast signal band when the lower local oscillation frequency is used as the local oscillation frequency of the local oscillator at the reception of the low-frequency band of the broadcasting reception frequency band, the oscillation-frequency switching means switches the local oscillation frequency of the local oscillator to the upper local oscillation frequency; if the image frequency falls out of the broadcast signal band when the upper local oscillation frequency is used as the local oscillation frequency of the local oscillator at the reception of the high-frequency band of the broadcasting reception frequency band, the oscillation-frequency switching means switches the local oscillation frequency of the local oscillator to the lower local oscillation frequency.

According to the information receiving apparatus of (4), the information receiving apparatus of (3) can put all the image frequencies of all the broadcast channels in the band of the broadcast signals. This enables to eliminate image interference across all the television broadcast channels while preventing complication of the circuit structure, and to improve reception quality while achieving miniaturization and light weight. Since the channel that needs switching between the upper local oscillation frequency and the lower local oscillation frequency can be determined by calculation in advance, additional circuits such as a signal-level sensor or a comparator are not necessary.

(5) An information receiving apparatus comprising:
   a first local oscillator that generates a first local oscillation signal whose local oscillation frequency is set so that the image frequency falls within a frequency band that is not used for radio communication or broadcasting;
   a first mixer that mixes a received signal with the first local oscillation signal to convert the received signal to a first intermediate-frequency signal;
   a first intermediate-frequency filter that filters the first intermediate-frequency signal;
   a second local oscillator that generates a second local oscillation signal;
   a second mixer that mixes the second local oscillation signal with the first intermediate-frequency signal to convert the first intermediate-frequency signal to a second intermediate-frequency signal; and
   a second intermediate-frequency filter that filters the second intermediate-frequency signal.

The information receiving apparatus of (5) can effectively eliminate image interference in a double super-heterodyne system and by simply controlling the local oscillation frequency, thus improving reception quality while achieving miniaturization and light weight.

(6) An information receiving apparatus comprising:
   a first local oscillator that generates a first local oscillation signal whose local oscillation frequency is set so that the image frequency falls within an unused frequency band between broadcast channels;
   a first mixer that mixes a received signal with the first local oscillation signal to convert the received signal to a first intermediate-frequency signal;
   a first intermediate-frequency filter that filters the first intermediate-frequency signal;
   a second local oscillator that generates a second local oscillation signal;
   a second mixer that mixes the second local oscillation signal with the first intermediate-frequency signal to convert the first intermediate-frequency signal to a second intermediate-frequency signal; and
   a second intermediate-frequency filter that filters the second intermediate-frequency signal.

The information receiving apparatus of (6) can effectively eliminate image interference across all television broadcast channels in a double super-heterodyne system and by setting the local oscillation frequency so that the image frequency falls within an unused frequency band between the broadcast channels.

(7) An information receiving apparatus comprising:
   a first local oscillator that generates a first local oscillation signal whose local oscillation frequency is set so that the image frequency falls within an unused frequency band between broadcast channels;
   a first mixer that mixes a received signal with the first local oscillation signal to convert the received signal to a first intermediate-frequency signal;
   a first intermediate-frequency filter that filters the first intermediate-frequency signal;
   a second local oscillator that generates a second local oscillation signal;
   a second mixer that mixes the second local oscillation signal with the first intermediate-frequency signal to convert the first intermediate-frequency signal to a second intermediate-frequency signal;
   a second intermediate-frequency filter that filters the second intermediate-frequency signal; and
   oscillation-frequency switching means that switches the local oscillation frequency of the first local oscillator between an upper local oscillation frequency and a lower local oscillation frequency so that the image frequency falls within a broadcast signal band.

The information receiving apparatus of (7) can stably eliminate image interference across all television broadcast channels by setting the local oscillation frequency so that the image frequency falls within an unused frequency band between the broadcast channels.

(8) The information receiving apparatus according to (7), wherein if the image frequency falls out of the broadcast signal band when the lower local oscillation frequency is used as the local oscillation frequency of the first local oscillator at the reception of the low-frequency band of the broadcasting reception frequency band, the oscillation-frequency switching means switches the local oscillation frequency of the first local oscillator to the upper local oscillation frequency; if the image frequency falls out of the broadcast signal band when the upper local oscillation frequency is used as the local oscillation frequency of the first local oscillator at the reception of the high-frequency band of the broadcasting reception frequency band, the oscillation-frequency switching means switches the local oscillation frequency of the first local oscillator to the lower local oscillation frequency.

According to the information receiving apparatus of (8), the information receiving apparatus of (7) adopts a double super-heterodyne system, and enables all the image frequencies of all broadcast channels to fall within the band of the broadcast signals.

(9) The information receiving apparatus according to one of (5) to (8), wherein the first intermediate-frequency filter is an SAW filter, and wherein the local oscillation frequency of the first local oscillation signal is set so that the frequency of the first intermediate-frequency signal falls within the range of 30 to 65 MHz.
   According to the information receiving apparatus of (9), the information receiving apparatus of one of (5) to (8) can provide significant reduction performance to an unnecessary frequency band, thus greatly reducing adjacent channel interference, and can set the central frequency of the SAW filter so as to facilitate manufacturing the SAW filter.

(10) A super-heterodyne information receiving apparatus comprising: a channel-selection operating section for channel selection; a local-oscillation-signal source; and a mixer that mixes a received signal with a local oscillation signal supplied from the local-oscillation-signal source to generate an intermediate-frequency signal, wherein the local-oscillation-signal source is constructed such that an upper local oscillation frequency and a lower local oscillation frequency are switched according to the result of channel selection by the channel-selection operating section so that the image frequency corresponding to the frequency of the local oscillation signal falls within the frequency band of the transmission wave of a station whose transmission power is relatively low.

With the information receiving apparatus of (10), the local-oscillation-signal source is constructed such that, when generating an intermediate-frequency signal by mixing a received signal with a local oscillation signal in a super-heterodyne system, an upper local oscillation frequency and a lower local oscillation frequency are switched according to the result of channel selection by the channel-selection operating section so that the image frequency corresponding to the frequency of the local oscillation signal falls within the frequency band of the transmission wave of a station whose transmission power is relatively low.

This arrangement decreases the degree of interference of the signal of the image frequency. Accordingly, even if the frequency of the local oscillation signal fluctuates to some extent, so that the image frequency enters the frequency band for use in broadcasting or communication, the degree of image interference can be relatively low.
The switching between the upper local oscillation frequency and the lower local oscillation frequency by the local-oscillation-signal source for reducing image interference is achieved by a simple switching method depending on the result of channel selection by the channel-selection operating section without the need for complicated process such as determining the actual signal level of the image frequency, thus not posing the disadvantage of complicating the structure.

(11) The information receiving apparatus according to (10), wherein the local-oscillation-signal source controls the switching between the upper local oscillation frequency and the lower local oscillation frequency with reference to released data on the transmission frequency and power of the broadcasting station according to the result of channel selection by the channel-selection operating section.
According to the information receiving apparatus of (11), the information receiving apparatus of (10) controls the switching between the upper local oscillation frequency and the lower local oscillation frequency with reference to the data on the transmission frequency and the transmission power of the broadcast channel according to the result of channel selection by the channel-selection operating section, e.g., registered in the form of a table. This requires no complicated structure for determining the actual signal level of the image frequency, and does not hinder the simplification of the structure.

(12) The information receiving apparatus according to (10), wherein: the super-heterodyne information receiving apparatus adopts a double super-heterodyne system; wherein the local-oscillation-signal source is the foremost local-oscillation-signal source; and wherein the mixer corresponds to the foremost local-oscillation-signal source.
According to the information receiving apparatus of (12), the information receiving apparatus of (10) adopts a double super-heterodyne system, in which the upper local oscillation frequency and the lower local oscillation frequency of the foremost local-oscillation-signal source are switched, as with the information receiving apparatus of (10). Thus, the degree of interference of the signal of the image frequency can be made lower. Accordingly, even if the frequency of the local oscillation signal fluctuates to some extent, so that the image frequency enters the frequency band for use in broadcasting and communication, image interference can be relatively low.

In this double super-heterodyne system also, the switching between the upper local oscillation frequency and the lower local oscillation frequency by the foremost local-oscillation-signal source for minimizing image interference is achieved by a simple switching method depending on the result of channel selection by the channel-selection operating section without the need for complicated process such as determining the actual signal level of the image frequency, thus not posing the disadvantage of complicating the structure.

(13) A super-heterodyne information receiving apparatus comprising: a channel-selection operating section for channel selection; a local-oscillation-signal source; and a mixer that mixes a received signal with a local oscillation signal supplied from the local-oscillation-signal source to generate an intermediate-frequency signal, wherein the local-oscillation-signal source is constructed so as to change the frequency of the local oscillation signal according to the result of channel selection by the channel-selection operating section so that the image frequency corresponding to the frequency of the local oscillation signal falls within the frequency band of the transmission wave of a station whose transmission power is relatively low.

With the information receiving apparatus of (13), when generating an intermediate-frequency signal by mixing a received signal with a local oscillation signal in a super-heterodyne system, the local-oscillation-signal source can change the frequency of the local oscillation signal according to the result of channel selection by the channel-selection operating section so that the image frequency corresponding to the frequency of the local oscillation signal falls within the frequency band of the transmission wave of a station whose transmission power is relatively low.

This arrangement enables the frequency of the local oscillation signal to be set so that the signal of the image frequency less works as interference waves. Accordingly, even if the frequency of the local oscillation signal fluctuates to some extent, so that the image frequency enters the frequency band for use in broadcasting and communication, image interference can be relatively low.
The change of the local oscillation frequency of the local-oscillation-signal source for reducing image interference to a relatively low level is achieved by a simple switching method depending on the result of channel selection by the channel-selection operating section without the need for complicated process such as determining the actual signal level of the image frequency, thus not posing the disadvantage of complicating the structure.

(14) The information receiving apparatus according to (13), wherein the local-oscillation-signal source controls the frequency of the local oscillation signal with reference to released data on the transmission frequency and power of the broadcasting station according to the result of channel selection by the channel-selection operating section.
According to the information receiving apparatus of (14), the information receiving apparatus of (13) controls the frequency of the local oscillation frequency with reference to the data on the transmission frequency and the transmission power of the broadcast channel according to the result of channel selection by the channel-selection operating section, e.g., registered in the form of a table. This requires no complicated structure for determining the actual signal level of the image frequency, and does not hinder the simplification of the structure.

(15) The information receiving apparatus according to (13), wherein: the super-heterodyne information receiving apparatus adopts a double super-heterodyne system; wherein the local-oscillation-signal source is the foremost local-oscillation-signal source; and wherein the mixer corresponds to the foremost local-oscillation-signal source.

According to the information receiving apparatus of (15), the information receiving apparatus of (13) adopts a double super-heterodyne system, and can change and set the frequency of the local oscillation frequency by the foremost local-oscillation-signal source so that the signal of the image frequency less works as interference waves, as with the information receiving apparatus of (13). Accordingly, even if the frequency of the local oscillation signal by the foremost local-oscillation-signal source fluctuates to some extent, so that the image frequency enters the frequency band for use in broadcasting and communication, image interference can be relatively low.

The change of the local oscillation frequency of the foremost local-oscillation-signal source for minimizing image interference is achieved by a simple switching method depending on the result of channel selection by the channel-selection operating section without the need for complicated process such as determining the actual signal level of the image frequency, thus not posing the disadvantage of complicating the structure.

(16) A method for receiving information by a super-heterodyne system in which a received signal is mixed with a local oscillation signal to generate an intermediate-frequency signal, wherein an upper local oscillation frequency and a lower local oscillation frequency are switched with reference to released data on the transmission frequency and power of the broadcasting station according to the result of channel selection so that the image frequency corresponding to the frequency of the local oscillation signal falls within the frequency band of the transmission wave of a station whose transmission power is relatively low.

In the method for receiving information of (16), when generating an intermediate-frequency signal by mixing a received signal with a local oscillation signal by a super-heterodyne system, an upper local oscillation frequency and a lower local oscillation frequency are switched according to the result of channel selection so that the image frequency corresponding to the frequency of the local oscillation signal falls within the frequency band of the transmission wave of a station whose transmission power is relatively low.
This arrangement decreases the degree of interference of the signal of the image frequency. Accordingly, even if the frequency of the local oscillation signal fluctuates to some extent, so that the image frequency enters the frequency band for use in broadcasting or communication, the degree of image interference can be relatively low.

(17) A method for receiving information by a super-heterodyne system in which a received signal is mixed with a local oscillation signal to generate an intermediate-frequency signal, wherein the frequency of the local oscillation signal is controlled with reference to released data on the transmission frequency and power of the broadcasting station according to the result of channel selection so that the image frequency corresponding to the frequency of the local oscillation signal falls within the frequency band of the transmission wave of a station whose transmission power is relatively low.

In the method for receiving information of (17), when generating an intermediate-frequency signal by mixing a received signal with a local oscillation signal in a super-heterodyne system, the frequency of the local oscillation signal is controlled according to the result of channel selection so that the image frequency corresponding to the frequency of the local oscillation signal falls within the frequency band of the transmission wave of a station whose transmission power is relatively low.
This arrangement enables the frequency of the local oscillation signal to be set so as to reduce the degree of interference of the signal of the image frequency. Accordingly, even if the frequency of the local oscillation signal fluctuates to some extent, so that the image frequency enters the frequency band for use in broadcasting or communication, the degree of image interference can be relatively low.

### [Brief Description of the Drawings]

Fig. 1 is a block diagram showing the schematic structure of an information receiving apparatus according to a first embodiment of the invention.
Fig. 2 is a diagram showing the relationship between digital terrestrial broadcasting channels and their frequencies.
Fig. 3 is a diagram showing the segment configuration of Channels 13 to 15 of digital terrestrial broadcasting.
Fig. 4 is a block diagram showing the schematic structure of an information receiving apparatus according to a second embodiment of the invention.
Fig. 5 is a block diagram showing the schematic structure of an information receiving apparatus according to a third embodiment of the invention.
Fig. 6 is a frequency allocation for describing the principle of a fourth embodiment of the invention.
Fig. 7 is a block diagram showing the schematic structure of an information receiving apparatus according to the fourth embodiment of the invention.
Fig. 8 is a frequency allocation for describing the principle of a fifth embodiment of the invention.
Fig. 9 is a block diagram showing the schematic structure of an information receiving apparatus according to the fifth embodiment of the invention.

### [Best Mode for Carrying Out the Invention]

Embodiments of the invention will be described hereinbelow with reference to the drawings. In the drawings, principal components that are the subjects of the description are suitably exaggerated and the other components are appropriately simplified or omitted for the purpose of convenience.

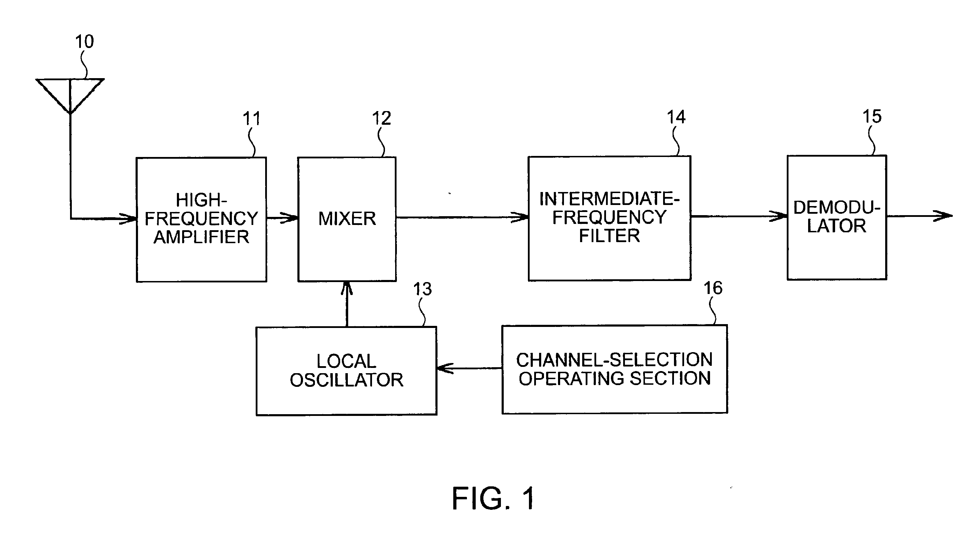

Fig. 1 is a block diagram showing the schematic structure of an information receiving apparatus according to a first embodiment of the invention.
Referring to Fig. 1, the information receiving apparatus includes: an antenna 10 that receives radio waves radiated into space; a high-frequency amplifier 11 that amplifies a high-frequency signal received by the antenna 10; a local oscillator 13 that generates a local oscillation signal; a mixer 12 that mixes the local oscillation signal generated by the local oscillator 13 with the received signal to convert the received signal to an intermediate-frequency signal; an intermediate-frequency filter 14 that extracts a desired band of the intermediate-frequency signal by filtering the intermediate-frequency signal output from the mixer 12; a demodulator 15 that demodulates the received signal converted to the intermediate-frequency signal; and a channel-selection operating section 16 that sends a selected broadcast channel to the local oscillator 13.

Examples of the local oscillator 13 include a voltage-control quartz oscillator, a phase-locked loop (PLL) circuit, and a delay-locked loop (DLL) circuit. An example of the information receiving apparatus includes an ISDB-T receiver. The channel-selection operating section 16 can select any of Channels 13 to 62. The local oscillator 13 sets the local oscillation frequency of the local oscillation signal so that the image frequency falls within the unused band between the broadcast channels.

On selection of a broadcast channel, the channel-selection operating section 16 sends the selected broadcast channel to the local oscillator 13. Upon reception of the broadcast channel from the channel-selection operating section 16, the local oscillator 13 sets the local oscillation frequency of the local oscillation signal so that the central receiving frequency of the broadcast channel is converted to an intermediate frequency with the image frequency nestled within the unused band between the broadcast channels.
The signal received by the antenna 10 is amplified by the high-frequency amplifier 11 and is then sent to the mixer 12. The mixer 12 also receives the local oscillation signal generated by the local oscillator 13. Upon reception of the received signal, the mixer 12 mixes it with the local oscillation signal, so that the received signal is converted to an intermediate-frequency signal.

The intermediate-frequency signal generated by the mixer 12 is sent to the intermediate-frequency filter 14, where a desired-band signal is extracted from the intermediate-frequency signal, and is then sent to the demodulator 15.
The demodulator 15 can demodulate the intermediate frequency to a frequency of 0.5 x 64/63 MHz (approximately 0.508 MHz), which can be most easily processed, using a numerical controlled oscillator (NCO) or a frequency offset circuit.

Here, setting the frequency of the local oscillation signal generated by the local oscillator 13 so that the image frequency falls within the unused band between broadcast channels can prevent the image frequency from entering the broadcast-channel use band when the received signal is converted to the intermediate-frequency signal. That is, the occurrence of image interference can be prevented simply by controlling the local oscillation frequency. This eliminates the need to use the image cancel mixer for eliminating image interference or to use means in which heterodyne system is switched to the system which has less image interference between an upper heterodyne and a lower heterodyne system like the related art, thus improving reception quality without hindering simplification of the circuit structure.

Having described a specific embodiment of a method for setting the local oscillation frequency of a local oscillation signal so that the image frequency falls within the unused band between broadcast channels, it is also possible to set the frequency of the local oscillation signal so that the image frequency falls within a frequency band that is not used in radio communication or broadcasting.

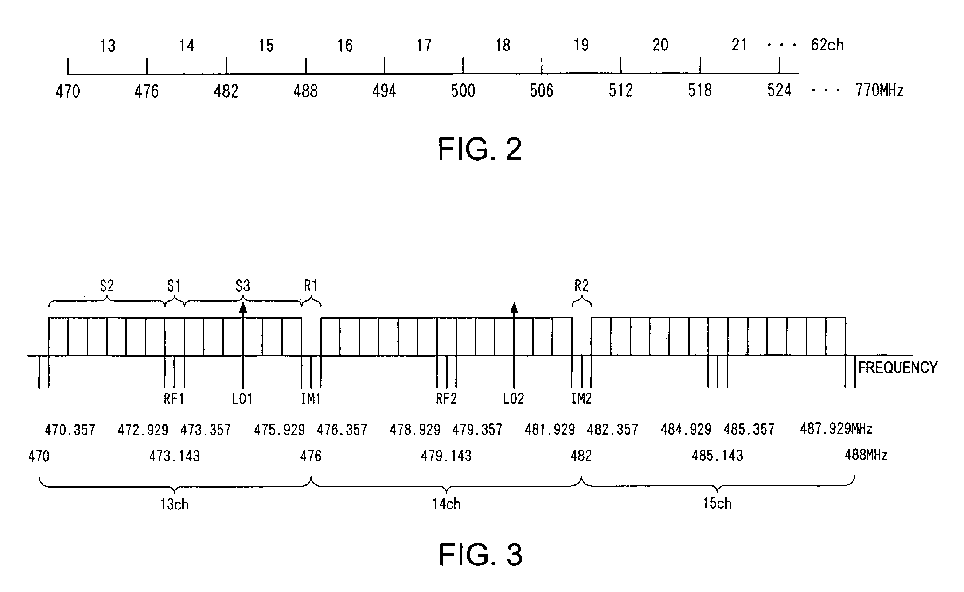

Fig. 2 is a diagram showing the relationship between digital terrestrial broadcasting channels and their frequencies.
Referring to Fig. 2, the digital terrestrial broadcasting has Channels 13 to 62, which are segmented every 6 MHz between 470 MHz to 770 MHz. Between the channels are provided unused regions of a bandwidth of approximately 428 KHz (corresponding to one segment).

Fig. 3 is a diagram showing the segment configuration of Channels 13 to 15 of digital terrestrial broadcasting.
Referring to Fig. 3, for Channel 13, the central receiving frequency is set to about 473.143 MHz, the lowest receiving frequency is set to about 470.357 MHz, the highest receiving frequency is set to about 475.929 MHz; for Channel 14, the central receiving frequency is set to about 479.143 MHz, the lowest receiving frequency is set to about 476.357 MHz, the highest receiving frequency is set to about 481.929 MHz; and for Channel 15, the central receiving frequency is set to about 485.143 MHz, the lowest receiving frequency is set to about 482.357 MHz, the highest receiving frequency is set to about 487.929 MHz.

In digital terrestrial broadcasting, the band of one channel of about 5.6 MHz is divided into 13 segments, of which Bands S2 and S3 corresponding to 12 segments except Band S1 corresponding to the central one segment are used for high-definition broadcasting, and Band S1 of the central one segment is used for services for mobile receivers.
To put an image frequency in the unused band between broadcasting channels in receiving digital terrestrial broadcasting, the local oscillation frequency is set so that the central receiving frequency falls within, e.g., the range of ±1.5 MHz, ±4.5 MHz, or ±7.5 MHz. In other words, the local oscillation frequency can be set to about 474.643 MHz + 6 x N (N = 0 to 49) in correspondence with digital terrestrial broadcasting Channels 13 to 62, respectively. In that case, the intermediate frequency amounts to 1.5 MHz.

Assume that local oscillation frequency LO1 is (central receiving frequency RF1 + 1.5) MHz and a signal of one segment of Channel 13 is received. Then, the central receiving frequency RF1 amounts to about 473.143 MHz, and the local oscillation frequency LO1 amounts to about 474.643 MHz. The image frequency IM1 amounts to about 476.143 MHz. The image frequency IM1 is in an unused region R1 between Channel 13 and Channel 14, so that the band of about 428 KHz (corresponding to one segment) becomes a no-signal state, thus preventing image interference.

Assume that local oscillation frequency is (central receiving frequency + 4.5) MHz and a signal of one segment of Channel 13 is received. Then, the local oscillation frequency amounts to about 477.643 M, and the image frequency amounts to about 482.143 M. The image frequency is in an unused region R2 between Channel 14 and Channel 15, so that a band of about 428 KHz (corresponding to one segment) becomes a no-signal state, thus preventing image interference.

Assume that local oscillation frequency is (central receiving frequency + 7.5) MHz and a signal of one segment of Channel 13 is received. Then, the local oscillation frequency amounts to about 480.643 M, and the image frequency amounts to about 488.143 M. The image frequency is in the unused region between Channel 15 and Channel 16, so that a band of about 428 KHz (corresponding to one segment) becomes a no-signal state, thus preventing image interference.
Since the band of one segment only for mobile reception is displaced by 6 MHz as is the central receiving frequency at every channels, image interference can be prevented whichever channel is selected.

Assume that local oscillation frequency LO2 is (central receiving frequency RF2 + 1.5) MHz and a signal of one segment of Channel 14 is received. Then, the central receiving frequency RF2 amounts to about 479.143 MHz, and the local oscillation frequency LO2 amounts to about 480.643 MHz. The image frequency IM2 amounts to about 482.143 MHz. The image frequency IM2 is in the unused region R2 between Channel 14 and Channel 15, so that a band of about 428 KHz (corresponding to one segment) becomes a no-signal state, thus preventing image interference.

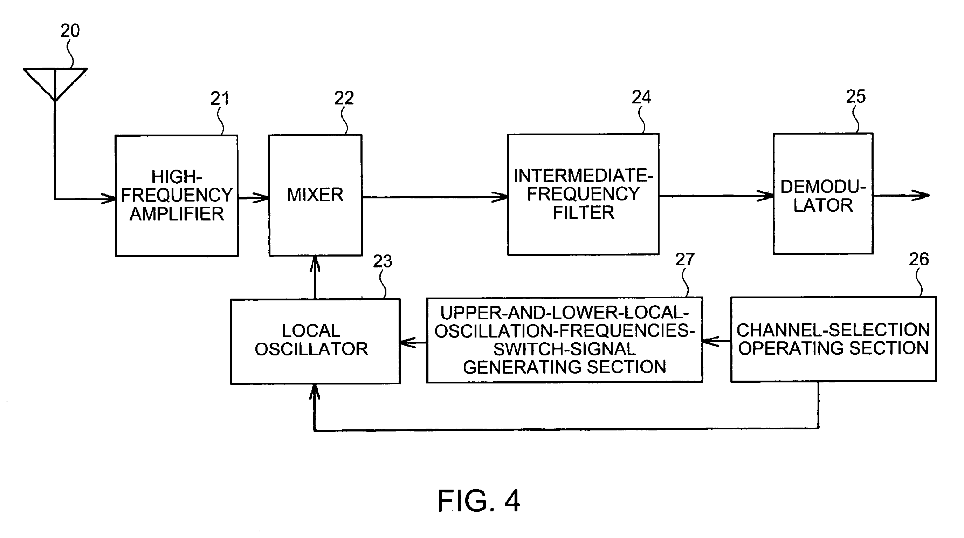

Fig. 4 is a block diagram showing the schematic structure of an information receiving apparatus according to a second embodiment of the invention.
Referring to Fig. 4, the information receiving apparatus includes an antenna 20 that receives radio waves radiated into space; a high-frequency amplifier 21 that amplifies a high-frequency signal received by the antenna 20; a local oscillator 23 that generates a local oscillation signal; a mixer 22 that mixes the local oscillation signal generated by the local oscillator 23 with the received signal to convert the received signal to an intermediate-frequency signal; an intermediate-frequency filter 24 that extracts a desired band of the intermediate-frequency signal by filtering the intermediate-frequency signal output from the mixer 22; a demodulator 25 that demodulates the received signal converted to the intermediate-frequency signal; a channel-selection operating section 26 that sends a selected broadcast channel to the local oscillator 23; and an upper-and-lower-local-oscillation-frequencies-switch-signal generating section 27 for switching between an upper local oscillation frequency and a lower local oscillation frequency so that the image frequency falls within the band of a broadcasting signal.

The local oscillator 23 can set the frequency of the local oscillation signal so that the image frequency falls within the unused band between the broadcast channels. The upper-and-lower-local-oscillation-frequencies-switch-signal generating section 27 can switch to an upper local oscillation frequency provided that the image frequency falls outside the band of the broadcasting signal when a lower local oscillation frequency of the broadcast receiving frequency band is used during low-frequency-region reception, and can switch to a lower local oscillation frequency provided that the image frequency is outside the band of the broadcasting signal when an upper local oscillation frequency of the broadcast receiving frequency band is used during high-frequency-region reception.

The channels whose image frequency comes out of the broadcast signal band when the upper local oscillation frequency or the lower local oscillation frequency is designated can be registered in the channel-selection operating section 26 in advance.
When a broadcast channel is selected, the channel-selection operating section 26 sends the selected broadcast channel to the local oscillator 23; when the image frequency of the selected broadcast channel falls out of the broadcast signal band, the channel-selection operating section 26 sends the broadcast channel to the upper-and-lower-local-oscillation-frequencies-switch-signal generating section 27.

Upon reception of the broadcast channel whose image frequency falls out of the broadcast signal band from the channel-selection operating section 26, the upper-and-lower-local-oscillation-frequencies-switch-signal generating section 27 outputs an upper-and-lower-local-oscillation-frequencies switch signal to the local oscillator 23.
Upon reception of the information on the broadcast channel from the channel-selection operating section 26, the local oscillator 23 sets the frequency of the local oscillation signal so that the central receiving frequency of the broadcast channel is converted to an intermediate frequency with the image frequency nestled within the unused band between the broadcast channels. Upon reception of the upper-and-lower-local-oscillation-frequencies switch signal from the upper-and-lower-local-oscillation-frequencies-switch-signal generating section 27, the local oscillator 23 switches between the upper local oscillation frequency and the lower local oscillation frequency.

The signal received by the antenna 20 is amplified by the high-frequency amplifier 21 and is then sent to the mixer 22. The mixer 22 also receives the local oscillation signal generated by the local oscillator 23. When the received signal is sent to the mixer 22, it is mixed with the local oscillation signal by the mixer 22 into an intermediate-frequency signal. The intermediate-frequency signal generated by the mixer 22 is sent to the intermediate-frequency filter 24, where a desired-band signal is extracted from the intermediate-frequency signal, and is then sent to the demodulator 25. The demodulator 25 demodulates the intermediate frequency to a frequency of 0.5 x 64/63 MHz (approximately 0.508 MHz) which can be most easily processed.

Thus all the image frequencies of all the broadcast channels can be put within the broadcast signal band. This enables to stably prevent image interference of all the television broadcast channels without hindering simplification of the circuit structure, thus improving reception quality while maintaining compact size and light weight.
On the other hand, when the central receiving frequency is about 473.143 MHz and the intermediate frequency is set to 4.5 MHz, so that when the lower local oscillation frequency is set to about 468.643 MHz, the image frequency becomes 464.143 MHz. In this state, the image frequency falls out of digital terrestrial broadcasting band, thus the no-signal state of the image frequency band is no ensured.

Thus, according to the embodiment of the invention, if the image frequency falls out of a digital terrestrial broadcasting band when the lower local oscillation frequency is used as a desired signal according to channel selection, the desired signal is switched to the upper local oscillation frequency according to channel selection. This switching enables the image frequency to fall within the digital terrestrial broadcasting band, and ensuring a state in which the image frequency band does not enter the broadcast signal band according to channel selection (substantially no-signal state).

On the other hand, if the central receiving frequency is about 767.143 MHz and the intermediate frequency is set to 4.5 MHz, so that when the upper local oscillation frequency is set to about 771.643 MHz, the image frequency comes to 776.143 MHz. In this state, the image frequency falls out of the digital terrestrial broadcasting band, thus disabling the no-signal state of the image frequency band.
Also in this case, according to the embodiment of the invention, if the image frequency falls out of the digital terrestrial broadcasting band when an upper local oscillation frequency is used as a desired signal according to channel selection, the desired signal is switched to a lower local oscillation frequency according to channel selection. This switching enables the image frequency to fall within the digital terrestrial broadcasting band, and ensuring a state in which the image frequency band does not enter the broadcast signal band according to channel selection (substantially no-signal state).

The switching between the upper local oscillation frequency and the lower local oscillation frequency corresponds to the switching between what is called an upper heterodyne system in which the local oscillation frequency is set (2 places) above the received signal and what is called a lower heterodyne system in which the local oscillation frequency is received below the received signal.

Such a technical idea is to be emphasized as the characteristic of the invention because conventional techniques do not have such a viewpoint that the local oscillation signal is switched so as to put the image frequency within the unused band of an available broadcast signal band (on the frequency axis) but not to fall out of the broadcast signal band (the outermost frequency band).
Although the arrangement of orthogonal frequency division multiplex (OFDM) signals is reversed when the upper local oscillation frequency and the lower local oscillation frequency are switched, it can be corrected by the demodulator 25.

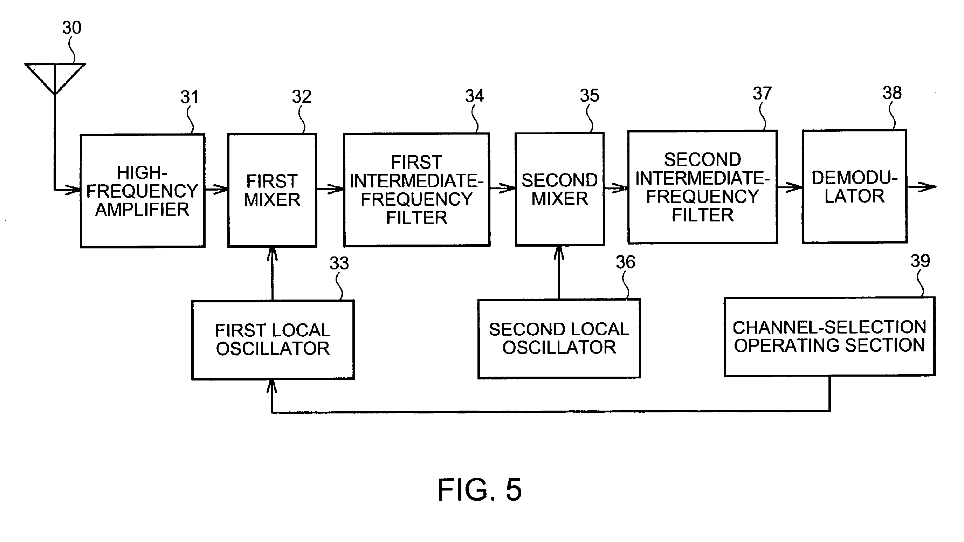

Fig. 5 is a block diagram showing the schematic structure of an information receiving apparatus according to a third embodiment of the invention.
Referring to Fig. 5, the information receiving apparatus includes an antenna 30 that receives radio waves radiated into space; a high-frequency amplifier 31 that amplifies a high-frequency signal received by the antenna 30; a first local oscillator 33 that generates a first local oscillation signal; a first mixer 32 that mixes the first local oscillation signal generated by the first local oscillator 33 with the received signal to convert the received signal to a first intermediate-frequency signal; a first intermediate-frequency filter 34 that extracts a desired band of the first intermediate-frequency signal by filtering the first intermediate-frequency signal output from the first mixer 32; a second local oscillator 36 that generates a second local oscillation signal; a second mixer 35 that mixes the second local oscillation signal generated by the second local oscillator 36 with the first intermediate-frequency signal to convert the first intermediate-frequency signal to a second intermediate-frequency signal; a second intermediate-frequency filter 37 that extracts a desired band of the second intermediate-frequency signal by filtering the second intermediate-frequency signal output from the second mixer 35; a demodulator 38 that demodulates the received signal converted to the intermediate-frequency signal; and a channel-selection operating section 39 that sends a selected broadcast channel to the first local oscillator 33.

Examples of the first local oscillator 33 include a voltage-control quartz oscillator, a PLL circuit, and a DLL circuit. The first local oscillator 33 can set the frequency of the first local oscillation signal so that the image frequency falls within the unused band between the broadcast channels.
In receiving digital terrestrial broadcasting, for example, the frequency of the first local oscillation signal can be set to approximately 504.643 + 6 x N (N = 0 to 49) MHz, while the frequency of the second local oscillation signal becomes a fixed frequency of about 32.008 MHz, when set so that the center frequency becomes 0.5 x 64/63 MHz (approximately 0.508 MHz) which can easily be processed by an OFDM demodulator.

On selection of a broadcast channel, the channel-selection operating section 39 sends the selected broadcast channel to the first local oscillator 33. Upon reception of the information on the broadcast channel from the channel-selection operating section 39, the first local oscillator 33 sets the frequency of the first local oscillation signal so that the central receiving frequency of the broadcast channel is converted to an intermediate frequency with the image frequency nestled within the unused band between the broadcast channels.

The signal received by the antenna 30 is amplified by the high-frequency amplifier 31 and is then sent to the first mixer 32. The first mixer 32 also receives the first local oscillation signal generated by the first local oscillator 33. When the received signal is sent to the first mixer 32, the signal is mixed with the first local oscillation signal by the first mixer 32 into a first intermediate-frequency signal.
The first intermediate-frequency signal generated by the first mixer 32 is sent to the first intermediate-frequency filter 34, where the first intermediate-frequency signal is filtered. The desired-band first intermediate-frequency signal extracted by the first intermediate-frequency filter 34 is sent to the second mixer 35. The second mixer 35 also receives a second local oscillation signal generated by the second local oscillator 36.

When the desired-band first intermediate-frequency signal extracted by the first intermediate-frequency filter 34 is sent to the second mixer 35, it is mixed with the second local oscillation signal by the second mixer 35, so that the first intermediate-frequency signal is converted to the second intermediate-frequency signal.
The second intermediate-frequency signal generated by the second mixer 35 is sent to the second intermediate-frequency filter 37, where a desired-band signal is extracted from the intermediate-frequency signal, and is then sent to the demodulator 38.

Thus, also by the double super-heterodyne system, image interference can be effectively prevented by simply controlling the local oscillation frequency, thus improving reception quality without hindering miniaturization and light weight.
Preferably, a surface acoustic wave (SAW) filter is used as the first intermediate-frequency filter 34, and the frequency of the first local oscillation signal is set so that the frequency of the first intermediate-frequency signal falls within the range of 30 to 65 MHz.

This enables to provide significant interrupt performance, thus greatly reducing adjacent channel interference, and to set the central frequency of the SAW filter so as to facilitate manufacturing of the SAW filter.
In other words, to greatly reduce adjacent channel interference, it is preferable to place the SAW filter therebetween as the first intermediate-frequency filter 34. The central frequency of an easy-to-manufacture SAW filter is on the order of 30 to 65 MHz in terms of manufacturing technique. Thus, in using the SAW filter as the first intermediate-frequency filter 34, it is preferable to set the intermediate frequency of the first intermediate-frequency signal to {31.5 + 3 x M (M = 0 to 11)} MHz.

For example, when M = 0, the intermediate frequency of the first intermediate-frequency signal is 31.5 MHz. Assume that Channel 13 is received. Then, the central receiving frequency is about 473.143 MHz, the upper local oscillation frequency is about 504.643 MHz, and the image frequency is about 536.143 MHz. In this case, the image frequency is in the unused band between Channel 23 and Channel 24, which falls within the no-signal band of about 428 KHz (corresponding to one segment), so that image interference can be prevented. Ditto for M = 1 to 11.

The embodiment of Fig. 5 has been described using an example in which the frequency of the local oscillation signal is set so that the image frequency falls within the unused band between broadcast channels. In contrast, when the image frequency falls out of the broadcast signal band, the upper local oscillation frequency and the lower local oscillation frequency may be switched so that the image frequency falls within the broadcast signal band, as in the foregoing embodiments.

Consequently, the invention is suited to OFDM communications used in digital broadcasting etc. This is because the spectrum of the OFDM signal is rectangular (rises and falls vertically), so that image interference can be greatly prevented provided that there is no local oscillator frequency error even if the desired signal band and the image signal band (in the invention, a no-signal band) are identical to each other. On the other hand, the signal spectrums of the amplitude modulation (AM) and the frequency modulation (FM) are not rectangular but are wide-based and vary with the degree of modulation. Accordingly, even without local oscillator frequency error, part of the spectrum may enter the image band that should have no signal to cause interference.

The inventor has invented a technique capable of overcoming possible problems under actual conditions through further consideration.
Specifically, the foregoing embodiments prevent image interference by locating the image frequency out of a band used in communication or broadcasting, e.g., in a section corresponding to a guard band, as viewed in frequency allocation.

This technique does not reduce already-generated image signals, as in conventional techniques, but prevents image interference effectively by locating the image signal in a specified section on the frequency axis where no resultant image interference occurs (by allowing the occurrence only in the section). Thus this can greatly reduce structural loads to reduce the image signals, or loads for processing the signals, as in the conventional techniques. Accordingly, as has been described, this arrangement can provide extremely excellent reception quality without influence of image interference and without hindering miniaturization and light weight as an information receiving apparatus.

This technique is very effective in obtaining excellent reception quality while achieving miniaturization and light weight. However, this technique requires an extremely high-accuracy local oscillator to embody.
Specifically speaking, in the above-described embodiments, the desired frequency band according to channel selection and the no-signal band for image frequency are the same 428 KHz, so that there is no margin for frequency error. However, it is extremely difficult to completely eliminate the fluctuations of the oscillation frequency of the local oscillator in simple meaning.

This requires allowing a fluctuation of the order of 10 ppm (e.g., 7.7 KHz for the rating of 770 MHz).
The following embodiment is intended to solve such actual problems, or plainly speaking, to completely prevent the influence of image interference by providing frequency allocation (by selecting the oscillation frequency of the local oscillator) such that the image signal is brought into a frequency band with lower transmission power.

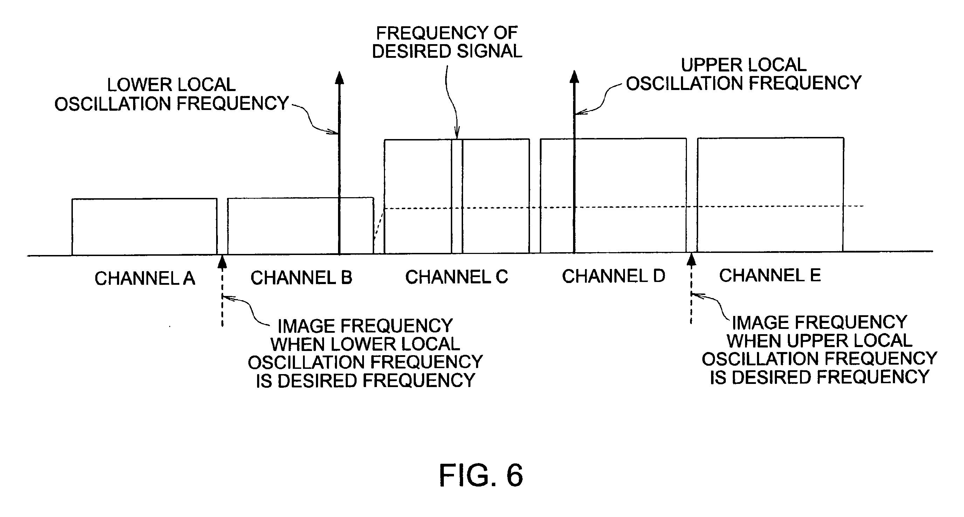

Fig. 6 is a frequency allocation for describing the principle of a fourth embodiment of the invention.
In Fig. 6, assume that the transmission powers of broadcast channels, Channel A and Channel B, are each 1 KW, and that the transmission powers of Channel C, Channel D, and Channel E are each 2 KW. In this case, when one segment of Channel C is received, the noise floor of the signal when the upper local oscillation frequency is a desired frequency is increased because of the noise distributed as indicated by the broken line even if the image signal falls within the no-signal band.

When the image signal is located in such a region, the influence by the fluctuation of the local oscillation frequency is relatively large.
In the embodiment of the invention, on the basis of an analysis of such a phenomenon, if the image signal when the upper local oscillation frequency is a desired frequency is located in a band with a larger signal level, an undesired rising of noise floor is prevented by switching the desired frequency to the lower local oscillation frequency.
Similarly, it is needless to say that when the image signal when the lower local oscillation frequency is a desired frequency is located in a band with a larger signal level, the desired frequency is switched to the upper local oscillation frequency.

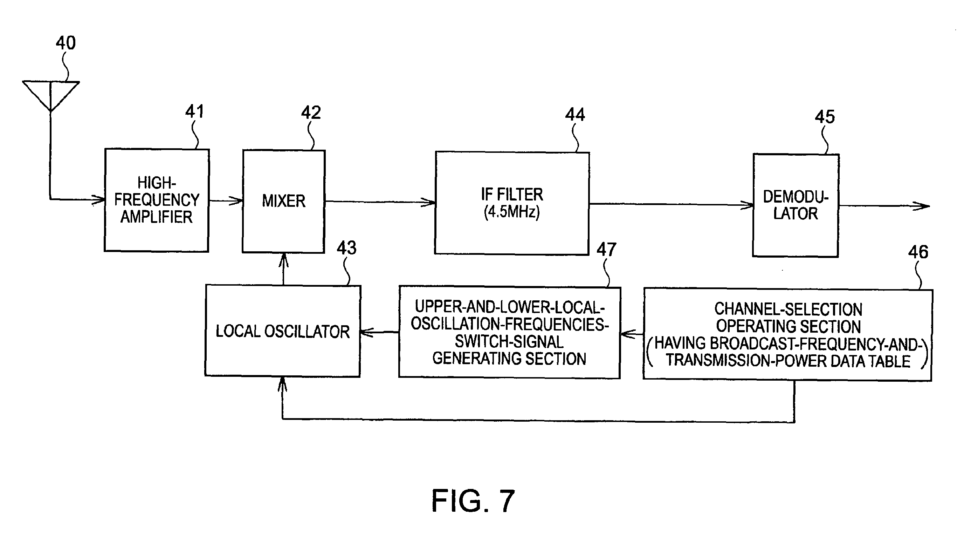

Fig. 7 is a block diagram showing the schematic structure of an information receiving apparatus according to the fourth embodiment of the invention.
Referring to Fig. 7, the information receiving apparatus includes an antenna 40 that receives radio waves radiated into space; a high-frequency amplifier 41 that amplifies a high-frequency signal received by the antenna 40; a local oscillator 43 that generates a local oscillation signal; a mixer 42 that mixes the local oscillation signal generated by the local oscillator 43 with the received signal to convert the received signal to an intermediate-frequency signal; an intermediate-frequency filter 44 (in the drawing, expressed as an IF filter) that extracts a desired band (e.g., 4.5 MHz) of the intermediate-frequency signal by filtering the intermediate-frequency signal output from the mixer 42; a demodulator 45 that demodulates the received signal converted to the intermediate-frequency signal; a channel-selection operating section 46 serving as a channel-selection operating section that receives channel selecting operation by a user and sends information on the selected broadcast channel to the local oscillator 43; and an upper-and-lower-local-oscillation-frequencies-switch-signal generating section 47 for switching between an upper local oscillation frequency and a lower local oscillation frequency so that the image frequency falls within the band of a transmission signal with lower power.

The local oscillator 43 switches between the upper local oscillation frequency and the lower local oscillation frequency in response to the switching instruction sent from the upper-and-lower-local-oscillation-frequencies-switch-signal generating section 47 so that the image frequency falls within a band with a lower transmission signal power.
The structure of this embodiment described with reference to Fig. 7 will be summarized hereinbelow to clarify the correspondence with the components of the invention.

The information receiving apparatus according to this embodiment is of a super heterodyne system including a channel-selection operating section (the channel-selection operating section 46) for channel selection; a local-oscillation-signal source (the local oscillator 43 and the upper-and-lower-local-oscillation-frequencies-switch-signal generating section 47); and a mixer (the mixer 42) that mixes the local oscillation signal supplied from the local-oscillation-signal source with the received signal to generate an intermediate-frequency signal. The local-oscillation-signal source (the local oscillator 43 and the upper-and-lower-local-oscillation-frequencies-switch-signal generating section 47) is constructed to switch between the upper local oscillation frequency and the lower local oscillation frequency according to the result of channel selection by the channel-selection operating section (the channel-selection operating section 46) so that the image frequency corresponding to the frequency of the local oscillation signal falls within the frequency band of transmitted radio waves of a station with a lower transmission power.

With this arrangement of the embodiment, the signal of the image frequency can be located in a frequency band in which the noise floor is less raised in the corresponding frequency band, thus decreasing the influence of interference waves. Accordingly, even if the frequency of the local oscillation signal fluctuates to an extent, so that the image frequency enters the frequency band for use in broadcasting or communication, the degree of image interference can be made relatively low.

The switching between the upper local oscillation frequency and the lower local oscillation frequency by the local-oscillation-signal source for minimizing image interference is achieved by a simple switching method depending on the result of channel selection by the channel-selection operating section (the channel-selection operating section 46) without the need for complicated process such as determining the actual signal level of the image frequency, thus not posing the disadvantage of complicating the structure.

In other words, in this embodiment, the switching between the upper local oscillation frequency and the lower local oscillation frequency is controlled according to the result of channel selection by the channel-selection operating section (the channel-selection operating section 46), or with reference to the data on the transmission frequency and the transmission power of the broadcast channel which appropriately stored, e.g., in the form of a table in the channel-selection operating section 46, in other words, according to specifically determined data. This requires no complicated structure for determining the actual signal level of the image frequency, not hindering the simplification of the structure.

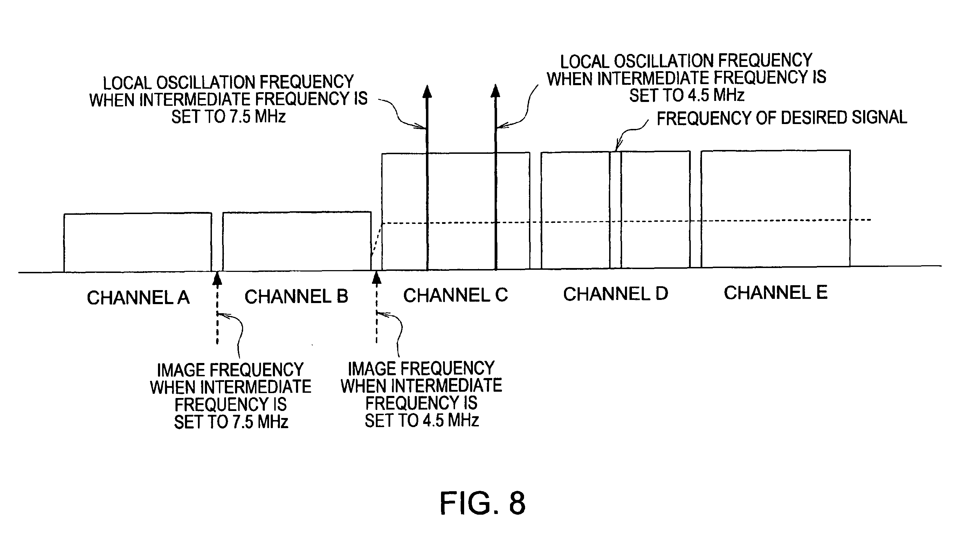

Fig. 8 is a frequency allocation for describing the principle of a fifth embodiment of the invention.
In Fig. 8, assume that the transmission powers of broadcast channels, Channel A and Channel B, are each 1 KW, and that the transmission powers of Channel C, Channel D, and Channel E are each 2 KW. In this case, if an intermediate frequency of 4.5 MHz is selected when one segment of Channel D is received, the corresponding image frequency is located at the region between Channel B and Channel C where the noise floor indicated by the broken line rises.

On the other hand, if an intermediate frequency of 7.5 MHz is selected when one segment of the same Channel D is received, the corresponding image frequency is located at the region between Channel A and Channel B where the noise floor is yet extremely low.
Accordingly, selecting 7.5 MHz as intermediate frequency when receiving one segment of Channel D has less influence of image interference, thus having an advantage in providing high reception quality.

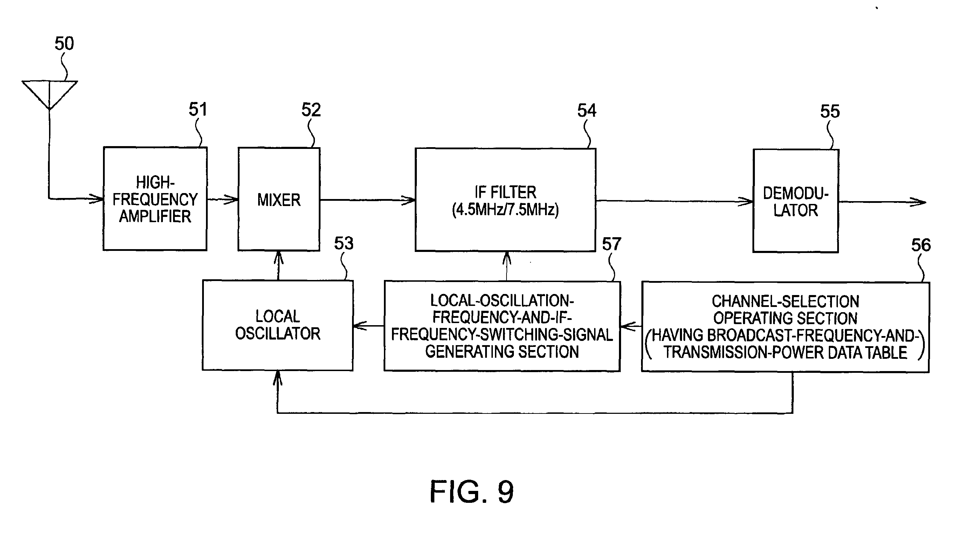

Fig. 9 is a block diagram showing the schematic structure of an information receiving apparatus according to the fifth embodiment of the invention.
Referring to Fig. 9, the information receiving apparatus includes an antenna 50 that receives radio waves radiated into space; a high-frequency amplifier 51 that amplifies a high-frequency signal received by the antenna 50; a local oscillator 53 that generates a local oscillation signal; a mixer 52 that mixes the local oscillation signal generated by the local oscillator 53 with the received signal to convert the received signal to an intermediate-frequency signal; an intermediate-frequency filter 54 (in the drawing, expressed as an IF filter) that extracts a desired band (e.g., 4.5 MHz or 7.5 MHz) of the intermediate-frequency signal by filtering the intermediate-frequency signal output from the mixer 52; a demodulator 55 that demodulates the received signal converted to the intermediate-frequency signal; a channel-selection operating section 56 serving as a channel-selection operating section that receives channel selecting operation by a user and sends information on the selected broadcast channel to the local oscillator 53; and a local-oscillation-frequency-and-IF-frequency-switching-signal generating section 57 for switching the local oscillation frequency and the intermediate frequency to appropriate values so that the image frequency falls within a band where the transmission signal power is relatively low.

The local oscillator 53 switches between the upper local oscillation frequency and the lower local oscillation frequency in response to the switching instruction sent from the local-oscillation-frequency-and-IF-frequency-switching-signal generating section 57 so that the image frequency falls within a band with a relatively low transmission signal power.
Correspondingly, the intermediate-frequency filter 54 also switches the characteristic in response to the switching instruction sent from the local-oscillation-frequency-and-IF-frequency-switching-signal generating section 57 so as to match an intermediate frequency corresponding to the frequency switching by the local oscillator 53.

The structure of this embodiment described with reference to Fig. 9 will be summarized hereinbelow to clarify the correspondence with the components of the invention.
The information receiving apparatus according to the embodiment is of a super-heterodyne system including a channel-selection operating section (the channel-selection operating section 56) for channel selection; a local-oscillation-signal source (the local oscillator 53 and the local-oscillation-frequency-and-IF-frequency-switching-signal generating section 57); and a mixer (the mixer 52) that mixes the local oscillation signal supplied from the local-oscillation-signal source with the received signal to generate an intermediate-frequency signal. The local-oscillation-signal source (the local oscillator 53 and the local-oscillation-frequency-and-IF-frequency-switching-signal generating section 57) is constructed so that the frequency of the local oscillation signal can be changed according to the result of channel selection by the channel-selection operating section (the channel-selection operating section 56) so that the image frequency corresponding to the frequency of the local oscillation signal falls within the frequency band of transmitted radio waves of a channel with a lower transmission power. As has been described, the characteristic of the intermediate-frequency filter 54 is switched so as to match an intermediate frequency corresponding to the change of the frequency of the local oscillation signal.

In this embodiment, the frequency of the local oscillation signal can be set so that the signal of the image frequency less works as interference waves. Accordingly, even if the frequency of the local oscillation signal fluctuates to some extent, so that the image frequency enters the frequency band for use in broadcasting or communication, the degree of image interference can be relatively low.

The change of the local oscillation frequency by the local-oscillation-signal source (the local oscillator 53 and the local-oscillation-frequency-and-IF-frequency-switching-signal generating section 57) for minimizing image interference and the change (switching) of the characteristic of the intermediate-frequency filter 54 with the change of the local oscillation frequency are achieved by a simple switching method depending on the result of channel selection by the channel-selection operating section (the channel-selection operating section 56) without the need for complicated process such as determining the actual signal level of the image frequency, thus not posing the disadvantage of complication of the structure.

In other words, in this embodiment, the control of the frequency of the local oscillation signal and the control of the characteristic of the intermediate-frequency filter 54 that goes therewith are performed according to the result of channel selection by the channel-selection operating section (the channel-selection operating section 56), or with reference to the data on the transmission frequency and the transmission power of the broadcast station which appropriately stored, e.g., in the form of a table in the channel-selection operating section 56, in other words, according to specifically determined data. This requires no complicated structure for determining the actual signal level of the image frequency, not hindering the simplification of the structure.

The super-heterodyne information receiving apparatus described with reference to Figs. 6 to 9 may be of a double super-heterodyne system, in which case it has the same structure on a block diagram as that of Fig. 5. With the double super-heterodyne system, the upper local oscillation frequency and the lower local oscillation frequency by the foremost local-oscillation-signal source (the first local oscillator 33 in Fig. 5) are switched according to channel selection, or alternatively, the frequency of the local oscillation signal from the foremost local-oscillation-signal source is changed according to channel selection.

With any of the structures, the frequency of the local oscillation signal can be set so that the signal of the image frequency less works as interference waves. Accordingly, even if the frequency of the local oscillation signal from the foremost local-oscillation-signal source fluctuates to some extent, so that the image frequency enters the frequency band for use in broadcasting and communication, image interference can be held relatively low.

The change of the local oscillation frequency of the foremost local-oscillation-signal source for minimizing image interference is achieved by a simple switching method depending on the result of channel selection by the channel-selection operating section without the need for complicated process such as determining the actual signal level of the image frequency, thus not posing the disadvantage of complicating the structure.

The above-described invention is a method for receiving information by a super-heterodyne system (Figs. 6 and 7) according to an aspect of the invention, in which a received signal is mixed with a local oscillation signal to generate an intermediate-frequency signal, in which an upper local oscillation frequency and a lower local oscillation frequency are switched with reference to released data on the transmission frequency and the transmission power of a broadcasting station according to the result of channel selection so that the image frequency corresponding to the frequency of the local oscillation signal falls within the frequency band of a station whose transmission power is relatively low.

According to an aspect of the invention, there is also provided a method for receiving information by a super-heterodyne system (Figs. 8 and 9) in which a received signal is mixed with a local oscillation signal to generate an intermediate-frequency signal, in which the frequency of the local oscillation signal is controlled with reference to released data on the transmission frequency and the transmission power of a broadcasting station according to the result of channel selection so that the image frequency corresponding to the frequency of the local oscillation signal falls within the frequency band of a station whose transmission power is relatively low. It goes without saying that these methods are technical ideas based on the above-described information receiving apparatus.

The methods of the invention both decrease the degree of interference due to the signal of the image frequency. Thus, even if the frequency of the local oscillation signal fluctuates to some extent, so that the image frequency enters the frequency band for use in broadcasting and communication, image interference can be relatively low in level, thus maintaining high reception quality.

### [Description of Numerals]

10, 20, 30, 40, 50: antenna, 11, 21, 31, 41, 51: high-frequency amplifier, 12, 22, 42, 52: mixer, 13, 23, 43, 53: local oscillator, 14, 24, 44, 54: intermediate-frequency filter, 15, 25, 38, 45, 55: demodulator, 16, 26, 39, 46, 56: channel-selection operating section, 27, 47: upper-and-lower-local-oscillation-frequencies-switch-signal generating section, 32: first mixer, 33: first local oscillator, 34: first intermediate-frequency filter, 35: second mixer, 36: second local oscillator, 37: second intermediate-frequency filter, 57: local-oscillation-frequency-and-IF-frequency-switching-signal generating section

## Claims

1. An information receiving apparatus comprising:
a local oscillator that generates a local oscillation signal whose local oscillation frequency is set so that the image frequency falls within a frequency band that is not used for radio communication or broadcasting;
a mixer that mixes a received signal with the local oscillation signal to convert the received signal to an intermediate-frequency signal; and
an intermediate-frequency filter that filters the intermediate-frequency signal.

2. An information receiving apparatus comprising:
a local oscillator that generates a local oscillation signal whose local oscillation frequency is set so that the image frequency falls within an unused frequency band between broadcast channels;
a mixer that mixes a received signal with the local oscillation signal to convert the received signal to an intermediate-frequency signal; and
an intermediate-frequency filter that filters the intermediate-frequency signal.

3. An information receiving apparatus comprising:
a local oscillator that generates a local oscillation signal whose local oscillation frequency is set so that the image frequency falls within an unused frequency band between broadcast channels;
a mixer that mixes a received signal with the local oscillation signal to convert the received signal to an intermediate-frequency signal;
an intermediate-frequency filter that filters the intermediate-frequency signal; and
oscillation-frequency switching means that switches the local oscillation frequency of the local oscillator between an upper local oscillation frequency and a lower local oscillation frequency so that the image frequency falls within a broadcast signal band.

4. The information receiving apparatus according to Claim 3, wherein if the image frequency falls out of the broadcast signal band when the lower local oscillation frequency is used as the local oscillation frequency of the local oscillator at the reception of the low-frequency band of the broadcasting reception frequency band, the oscillation-frequency switching means switches the local oscillation frequency of the local oscillator to the upper local oscillation frequency; if the image frequency falls out of the broadcast signal band when the upper local oscillation frequency is used as the local oscillation frequency of the local oscillator at the reception of the high-frequency band of the broadcasting reception frequency band, the oscillation-frequency switching means switches the local oscillation frequency of the local oscillator to the lower local oscillation frequency.

5. An information receiving apparatus comprising:
a first local oscillator that generates a first local oscillation signal whose local oscillation frequency is set so that the image frequency falls within a frequency band that is not used for radio communication or broadcasting;
a first mixer that mixes a received signal with the first local oscillation signal to convert the received signal to a first intermediate-frequency signal;
a first intermediate-frequency filter that filters the first intermediate-frequency signal;
a second local oscillator that generates a second local oscillation signal;
a second mixer that mixes the second local oscillation signal with the first intermediate-frequency signal to convert the first intermediate-frequency signal to a second intermediate-frequency signal; and
a second intermediate-frequency filter that filters the second intermediate-frequency signal.

6. An information receiving apparatus comprising:
a first local oscillator that generates a first local oscillation signal whose local oscillation frequency is set so that the image frequency falls within an unused frequency band between broadcast channels;
a first mixer that mixes a received signal with the first local oscillation signal to convert the received signal to a first intermediate-frequency signal;
a first intermediate-frequency filter that filters the first intermediate-frequency signal;
a second local oscillator that generates a second local oscillation signal;
a second mixer that mixes the second local oscillation signal with the first intermediate-frequency signal to convert the first intermediate-frequency signal to a second intermediate-frequency signal; and
a second intermediate-frequency filter that filters the second intermediate-frequency signal.

7. An information receiving apparatus comprising:
a first local oscillator that generates a first local oscillation signal whose local oscillation frequency is set so that the image frequency falls within an unused frequency band between broadcast channels;
a first mixer that mixes a received signal with the first local oscillation signal to convert the received signal to a first intermediate-frequency signal;
a first intermediate-frequency filter that filters the first intermediate-frequency signal;
a second local oscillator that generates a second local oscillation signal;
a second mixer that mixes the second local oscillation signal with the first intermediate-frequency signal to convert the first intermediate-frequency signal to a second intermediate-frequency signal;
a second intermediate-frequency filter that filters the second intermediate-frequency signal; and
oscillation-frequency switching means that switches the local oscillation frequency of the first local oscillator between an upper local oscillation frequency and a lower local oscillation frequency so that the image frequency falls within a broadcast signal band.

8. The information receiving apparatus according to Claim 7, wherein if the image frequency falls out of the broadcast signal band when the lower local oscillation frequency is used as the local oscillation frequency of the first local oscillator at the reception of the low-frequency band of the broadcasting reception frequency band, the oscillation-frequency switching means switches the local oscillation frequency of the first local oscillator to the upper local oscillation frequency; if the image frequency falls out of the broadcast signal band when the upper local oscillation frequency is used as the local oscillation frequency of the first local oscillator at the reception of the high-frequency band of the broadcasting reception frequency band, the oscillation-frequency switching means switches the local oscillation frequency of the first local oscillator to the lower local oscillation frequency.

9. The information receiving apparatus according to one of Claims 5 to 8, wherein the first intermediate-frequency filter is an SAW filter, and wherein the local oscillation frequency of the first local oscillation signal is set so that the frequency of the first intermediate-frequency signal falls within the range of 30 to 65 MHz.

10. A super-heterodyne information receiving apparatus comprising: a channel-selection operating section for channel selection; a local-oscillation-signal source; and a mixer that mixes a received signal with a local oscillation signal supplied from the local-oscillation-signal source to generate an intermediate-frequency signal, wherein the local-oscillation-signal source is constructed such that an upper local oscillation frequency and a lower local oscillation frequency are switched according to the result of channel selection by the channel-selection operating section so that the image frequency corresponding to the frequency of the local oscillation signal falls within the frequency band of the transmission wave of a station whose transmission power is relatively low.

11. The information receiving apparatus according to Claim 10, wherein the local-oscillation-signal source controls the switching between the upper local oscillation frequency and the lower local oscillation frequency with reference to released data on the transmission frequency and power of the broadcasting station according to the result of channel selection by the channel-selection operating section.

12. The information receiving apparatus according to Claim 10, wherein: the super-heterodyne information receiving apparatus adopts a double super-heterodyne system; wherein the local-oscillation-signal source is the foremost local-oscillation-signal source; and wherein the mixer corresponds to the foremost local-oscillation-signal source.

13. A super-heterodyne information receiving apparatus comprising: a channel-selection operating section for channel selection; a local-oscillation-signal source; and a mixer that mixes a received signal with a local oscillation signal supplied from the local-oscillation-signal source to generate an intermediate-frequency signal, wherein the local-oscillation-signal source is constructed so as to change the frequency of the local oscillation signal according to the result of channel selection by the channel-selection operating section so that the image frequency corresponding to the frequency of the local oscillation signal falls within the frequency band of the transmission wave of a station whose transmission power is relatively low.

14. The information receiving apparatus according to Claim 13, wherein the local-oscillation-signal source controls the frequency of the local oscillation signal with reference to released data on the transmission frequency and power of the broadcasting station according to the result of channel selection by the channel-selection operating section.

15. The information receiving apparatus according to Claim 13, wherein: the super-heterodyne information receiving apparatus adopts a double super-heterodyne system; wherein the local-oscillation-signal source is the foremost local-oscillation-signal source; and wherein the mixer corresponds to the foremost local-oscillation-signal source.

16. A method for receiving information by a super-heterodyne system in which a received signal is mixed with a local oscillation signal to generate an intermediate-frequency signal, wherein an upper local oscillation frequency and a lower local oscillation frequency are switched with reference to released data on the transmission frequency and power of the broadcasting station according to the result of channel selection so that the image frequency corresponding to the frequency of the local oscillation signal falls within the frequency band of the transmission wave of a station whose transmission power is relatively low.

17. A method for receiving information by a super-heterodyne system in which a received signal is mixed with a local oscillation signal to generate an intermediate-frequency signal, wherein the frequency of the local oscillation signal is controlled with reference to released data on the transmission frequency and power of the broadcasting station according to the result of channel selection so that the image frequency corresponding to the frequency of the local oscillation signal falls within the frequency band of the transmission wave of a station whose transmission power is relatively low.
